# EUROPEAN PATENT SPECIFICATION

(11) **EP 2 326 005 B1**
(45) Date of publication and mention of the grant of the patent: **22.08.2012**
(21) Application number: 11156482.9
(22) Date of filing: 30.11.2007
(51) Int. Cl.: H03K 17/082

(54) **Solid state power controller with lightning protection**
Festkörperleistungsregler mit Blitzschutz
Contrôleur d'alimentation à l'état solide avec protection d'éclairage

(30) Priority: 30.11.2006 US 606795
(43) Date of publication of application: 25.05.2011
(62) Divisional of application: 07254652.6
(73) Proprietor: Hamilton Sundstrand Corporation, Windsor Locks, CT 06096-1010 (US)
(72) Inventor: Kilroy, Donald G., Rockford, IL 61108 (US); Robertson, Nicholas J., Rockford, IL 61107 (US); Maier, Josef, 86754 Munningen (DE); Lofflad, Bernd, 86720 Nördlingen-Löpsingen (DE)
(74) Representative: Tomlinson, Kerry John

(56) References cited:
- US-A- 5 752 047
- US-A1- 2004 156 154
- US-A1- 2006 101 296
- US-B1- 6 525 918

## Description

### BACKGROUND OF THE INVENTION

This invention relates to vehicle power systems and, more particularly, to solid state power controls.

US 2006/101296 A1 discloses an electric load management center including a plurality of load management modules each comprising a plurality of solid state power switching devices.

Vehicles, such as aircraft, typically utilize one or more power distribution units to distribute power from a primary power source to various vehicle systems. The solid state power controls in a power distribution unit typically include an electronic switch, such as a FET, and electronic circuitry that provides wiring protection. The FET and circuitry are often referred to as a solid state power controller ("SSPC"). The SSPC has found widespread use because of its desirable status capability, reliability, and packaging density. A typical power distribution unit may include hundreds or thousands of SSPCs.

SSPCs also must operate in the presence of lightning, which can adversely impact electronic devices. Traditionally, aircraft had an aluminum skin that attenuated the lightning current induced on the wires. Some aircraft now use composite materials instead of aluminum for weight and strength benefits. However, composite materials do not provide the same level of attenuation to lightning as aluminum. When lightning occurs, hundreds of volts may surge between a load in the vehicle system and the aircraft chassis. As such, the lightning requirements of SSPCs have increased.

The increase in lightning levels poses a significant additional burden because the SSPC does not provide galvanic isolation in the off state, as would a typical electro-mechanical circuit for example. Instead, the SSPC uses the FET for switching and the electronic circuit to provide the circuit breaker function. If the SSPC is in an off state when lightning strikes, the large voltage potential will undesirably increase the voltage across the FET. An over-voltage clamp can be used to protect the FET from exceeding its maximum voltage capability by placing the FET into a linear region. However, the increased power dissipation of the FET in the linear region limits the amount of lightning energy that can be dissipated. Alternatively, high voltage FETs may be used to block the voltage in the off state, transient suppression devices can be placed across the FETs or more parallel FETs may be added, but these solutions are expensive, require larger packaging, and reduce reliability. Additionally, to protect the loads, a transient voltage suppression is often used by the load to shunt or divert the lightning current. This further increases the lightning energy that the SSPC must survive.

There is a need for a simple, relatively inexpensive method of controlling a SSPC with improved lightning protection. This invention addresses those needs while avoiding the shortcomings and drawbacks of the prior art.

### SUMMARY OF THE INVENTION

The present invention provides a method of controlling a solid state power controller, comprising selectively allowing a current through a solid state power control switch in response to a plurality of protective circuit breaker trips being activated in a plurality of solid state power controllers within a predetermined time.

The invention enables the SSPC to survive a lightning threat and return a load to its defined state once the threat has passed. The method described is suitable for most single-stroke lightning applications and may be suitable for many multiple-stroke lightning applications. However, additional enhancements can be made to prevent repeated potential cycling off and on under an auto-recover mechanism during a multiple-stroke lightning application. There is a need for a simple, relatively inexpensive SSPC with improved lightning protection, that is suitable for exposure to multiple-stroke lightning, that can operate within a lightning environment with minimal system disruption, and that can protect loads from multiple power cycling.

In some embodiments, an arc fault protection is disabled for the duration of a power surge.

### BRIEF DESCRIPTION OF THE DRAWINGS

The various features and advantages of this invention will become apparent to those skilled in the art from the following detailed description of the currently preferred embodiment. The drawings that accompany the detailed description can be briefly described as follows.

Figure 1 illustrates selected portions of an example solid state power controller for use in the method of the present invention.

Figure 2 illustrates a microprocessor module and a plurality of SSPCs that communicate through a serial hardware interface.

Figure 3 illustrates a plurality of power distribution units and an associated microprocessor module in an example environment of an aircraft.

### DETAILED DESCRIPTION OF THE PREFERRED EMBODIMENTS

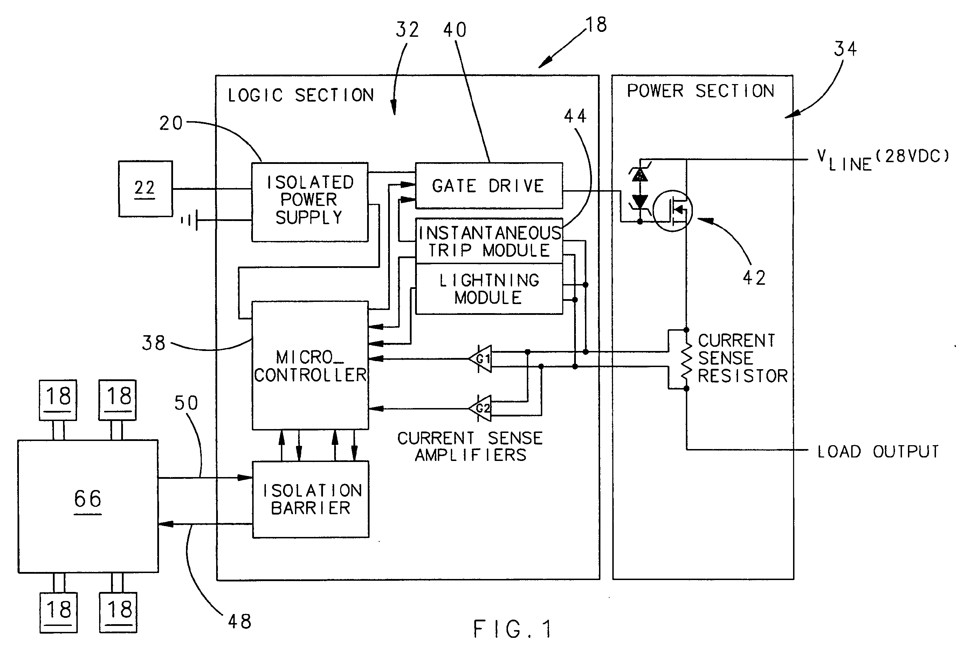

Figure 1 illustrates selected portions of an example solid state power controller (SSPC) 18 for use in a vehicle, such as an aircraft. Under some conditions, such as a lightning strike, a transient current may surge through the vehicle. The transient current may be, for example, an induced current, other known types of transient current, or a transient current from another source besides lightning. In the disclosed example, the SSPC 18 provides lightning protection to reduce the risk that the SSPC 18 becomes damaged from the transient current. As will be appreciated from the illustration and the following description, the SSPC 18 of the disclosed examples provides lightning protection without significant packaging density, reliability, or cost penalty. Although the SSPC 18 is a direct current type in the disclosed examples, one of ordinary skill in the art who has the benefit of this disclosure will recognize that the disclosed examples are also applicable to alternating current type SSPCs.

In this example, the SSPC 18 includes a logic section 32 and a power section 34. The logic section 32 includes a power supply 20, which provides power to a microcontroller 38 that controls operation of the SSPC 18. Power supply 20 is connected both to ground and to a power source 22. The microcontroller 38 interfaces with a gate drive 40, a switch 42, an instantaneous trip module 44, and a lightning module 46. Although only one switch 42 is shown in this example, multiple switches 42 may be used in the same manner as described. The instantaneous trip module 44 and lightning module 46 sense the electrical current flow through the SSPC 18.

The instantaneous trip module 44 includes associated instantaneous trip logic. The SSPC 18 responds in a variety of ways to a transient current, depending on the magnitude of the current flowing through the SSPC 18, a preset instantaneous trip threshold associated with the instantaneous trip module 44, and whether the SSPC 18 is an ON state (e.g., switch 42 is closed/ON) or an OFF state (e.g., switch 42 is open/OFF).

Currents larger than the instantaneous trip threshold are possible with loads that have transient voltage suppression (e.g., shunts) or loads that are highly capacitive in nature. In the disclosed example, the switch 42 includes a voltage clamp circuitry that protects the switch 42 in a known manner from certain voltage transients. The voltage clamp activates in a linear region to dissipate energy to thereby absorb transient currents up to the instantaneous trip threshold. Beyond the instantaneous trip threshold, the instantaneous trip module 44 and its associated logic protect the SSPC 18 from the transient current, as will be described below.

The following examples illustrate the operation of the instantaneous trip module 44 under various conditions for transient currents. In one of the disclosed examples, turning ON the SSPC 18 passes the transient current to the load and thereby protects against formation of a fusible link and destruction of the switch 42. The below examples are intended only to illustrate concepts of the instantaneous trip module 44, and one of ordinary skill who is given this description will recognize application of the concepts to other examples.

In one example, the SSPC 18 is OFF when the transient current occurs. Under this condition (i.e., SSPC 18 OFF), the only time that the current is expected to increase above the instantaneous trip threshold is if the SSPC 18 line Vₗᵢₙₑ or load output connection is shorted to a source voltage that exceeds the switch 42 over-voltage clamp protection, or if the SSPC 18 line Vₗᵢₙₑ or load connection is coupled to a transient voltage that exceeds the switch 42 over-voltage clamp protection. The switch 42 over-voltage clamp protects the switch 42 by turning on in a linear region to dissipate energy in a known manner. This provides the benefit of absorbing transient currents up to the instantaneous trip threshold. If, however, the transient current exceeds the instantaneous trip threshold, the instantaneous trip module and its associated logic function to protect the switch 42.

In the disclosed example, if the transient current increases above the instantaneous trip threshold, the instantaneous trip module 44 turns on the gate drive 40 to turn ON the switch 42. In this example, the switch 42 can handle more transient current when ON because the voltage across the switch 42 will be lower, which reduces the transient energy that switch 42 must absorb. The transient current flows to the load during this time to thereby protect the SSPC 18 from damage. As the transient current decreases below the instantaneous trip threshold, the instantaneous trip module 44 removes the gate drive 40 command to force the switch 42 OFF. Optionally, a time delay is used before turning off gate drive 40 to allow the SSPC 18 to cool.

The direct communication between the instantaneous trip module 44 and the gate drive 40 provides the benefit of allowing transient current protection even when the microcontroller 38 is in an inactive mode (e.g., a sleep mode). In a sleep mode for example, the microcontroller 38 software will not be awake to control the SSPC 18 to respond to a lightning threat. By directly linking the instantaneous trip module 44 and the gate drive 40, the instantaneous trip module 44 can directly control the gate drive 40 without the microcontroller 38 to quickly turn ON the switch 42.

In another example, the SSPC 18 is ON when the transient current occurs. The transient current increases the current through the switch 42 until the instantaneous trip threshold is exceeded. At this point, the microcontroller 38 begins to turn OFF the switch 42 and set an auto-recover function. The process of turning OFF the switch 42 takes some time, typically fractions of a second. During this time, the current may increase, decrease, or remain steady.

If the transient current decreases or remains steady, the switch 42 turns OFF and the auto-recover logic functions to turn the SSPC 18 back ON after a time delay time to allow cooling.

After the switch 42 is turned back ON, if the current remains above the instantaneous trip threshold, the switch 42 turns OFF and the auto-recover logic again functions to turn the SSPC 18 back ON after another time delay time to allow cooling. It is assumed that current above the instantaneous trip threshold is from a shorted load and not lightning if multiple attempts to auto-recover continue to produce current above the instantaneous trip threshold. In response, a protective trip is set in the microcontroller 38, and the SSPC 18 turns OFF.

The auto-recover logic provides the benefit of automatically resetting the switch 42 without the need for manual resetting (e.g., from an aircraft pilot), which is a drawback of prior SSPCs.

For the purposes of this discussion, the example solid state power controller (SSPC) 18 shown in Figure 1 comprises a single FET, while in practice it is common to have multiple FETs in parallel. The logic section 32 includes the isolated power supply 20, which channels power from the power source 22 to the microcontroller 38 and the gate drive 40. The microcontroller 38 controls gate drive 40, which opens and closes the switch 42. When the gate drive 40 is turned on, the switch 42 is closed and the SSPC 18 turns ON. When the gate drive 40 is turned off, the switch 42 is opened and the SSPC 18 turns OFF. Although only one switch 42 is shown in this example, multiple switches may be used in the same manner as described. The instantaneous trip module 44 senses the electrical current flow through the SSPC 18. Instantaneous trip module 44 acts as a comparator, and determines when current meets or exceeds the instantaneous trip threshold. Microcontroller 38 transmits data to an SSPC communications interface 66 via communications line 48. The SSPC communications interface 66 transmits data back to the microcontroller 38 via communications line 50. The SSPC communications interface 66 also communicates with other SSPCs 18.

Under some conditions, such as a lightning strike, a transient current may surge through the vehicle. The transient current may be, for example, an induced current, other known type of transient current, or a transient current from another source besides lightning. In the disclosed example, the SSPC 18 provides lightning protection to reduce the risk that the SSPC 18 becomes damaged from the transient current.

Although the SSPC 18 as shown in Figure 1 is a direct current type, one of ordinary skill in the art who has the benefit of that disclosure will recognize that the disclosed examples are also applicable to alternating current type SSPCs.

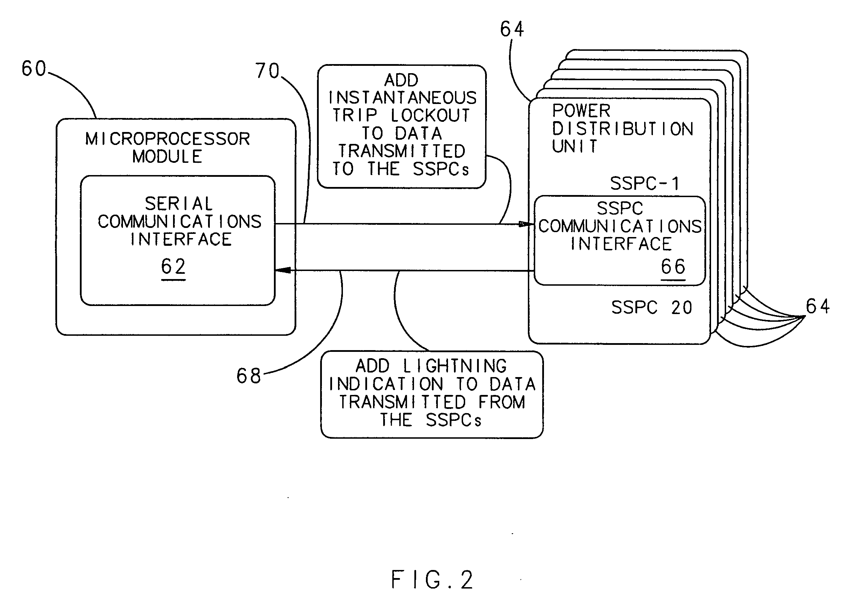

Figure 2 illustrates how a microprocessor module 60 communicates with a plurality of power distribution units 64, which each contain a plurality of SSPCs. The microprocessor module 60 has a serial communications interface 62, and each of the plurality of power distribution units 64 has an SSPC communications interface 66. The power distribution units 64 transmit serial data over communication line 68 to the microprocessor module 60. The microprocessor module 60 transmits serial data over communication line 70 to the plurality of power distribution units 64. All of the serial data is communicated between the interfaces 62 and 66.

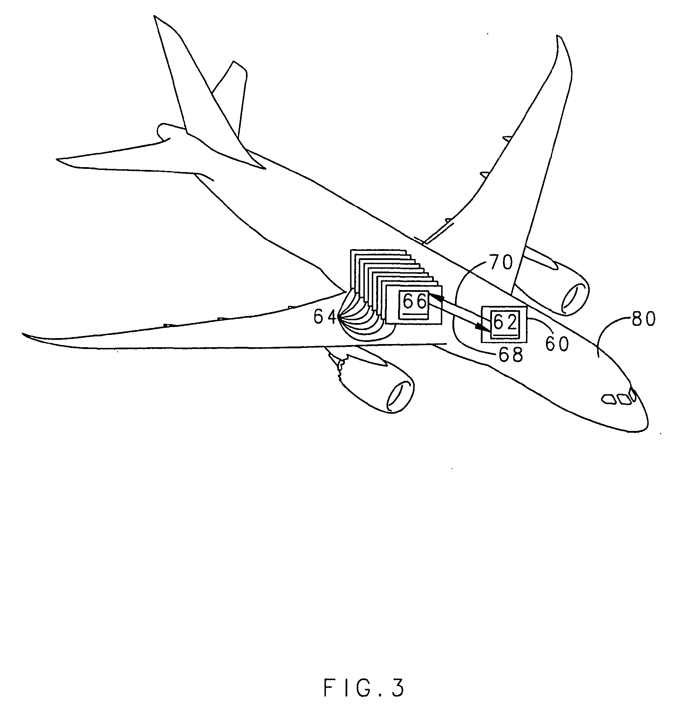

Figure 3 illustrates a microprocessor module 60 and a plurality of power distribution units 64 in an example environment of an aircraft 80. Serial data is transmitted between the microprocessor module 60 and the plurality of power distribution units 64 via communications interfaces 62 and 66 and serial data communication lines 68 and 70.

If certain conditions are met, the microprocessor module 60 may determine that a lightning pulse has occurred. In one embodiment, when an SSPC experiences multiple instantaneous trips within a predetermined time, it will turn off its SSPC output and set a circuit breaker protective trip by opening the switch 42, as described above. In this embodiment, microprocessor module 60 monitors each SSPC for a circuit breaker protective trip. If a sufficient number of circuit breaker protective trips have been activated within a preset defined period, the microprocessor module 60 may reset the tripped SSPCs so that current may pass to a load or plurality of loads, leaving the SSPCs undamaged and reducing the impact to the vehicle from multiple instances of tripped SSPCs from a common cause event such as lightning.

Although preferred embodiments of this invention have been disclosed, a worker of ordinary skill in this art would recognize that certain modifications would come within the scope of this invention. For that reason, the following claims should be studied to determine the true scope and content of this invention.

## Claims

1. A method of controlling a solid state power controller, comprising selectively allowing a current through a solid state power control switch in response to a plurality of protective circuit breaker trips being activated in a plurality of solid state power controllers within a predetermined time.

2. The method as claimed in claim 1, wherein a circuit breaker protective trip is activated if a solid state power controller experiences multiple instantaneous trips within a predetermined time, wherein each instantaneous trip is responsive to a transient current flowing through the solid state power controller exceeding an instantaneous trip threshold.

3. The method as claimed in claim 1 or 2, wherein a circuit breaker protective trip is reset if multiple solid state power controllers within a group experience circuit breaker protective trips within a predetermined time.

4. The method as claimed in any preceding claim wherein an arc fault protection is disabled for the duration of a power surge.

## Patentansprüche

1. Steuerverfahren für eine Halbleiterleistungssteuereinrichtung aufweisend wahlweise Zulassen eines Stroms durch einen Halbleiterleistungssteuerschalter in Reaktion darauf, dass eine Vielzahl von Leitungsunterbrecher-Schutzauslöseeinrichtungen in einer Vielzahl von Halbleiterleistungssteuereinrichtungen innerhalb einer vorbestimmten Zeit aktiviert wird.

2. Verfahren gemäß Anspruch 1, wobei eine Leitungsunterbrecher-Schutzauslöseeinrichtung aktiviert wird, wenn bei einer Halbleiterleistungssteuereinrichtung eine Vielzahl von Schnellauslösungen innerhalb einer vorbestimmten Zeit auftreten, wobei jede Schnellauslösung eine Reaktion auf einen durch die Halbleiterleistungssteuerungseinrichtung fließenden Überlaststrom ist, der eine Schnellauslöseschwelle überschreitet.

3. Verfahren gemäß Anspruch 1 oder 2, wobei eine Leitungsunterbrecher-Schutzauslöseeinrichtung zurückgesetzt wird, wenn bei einer Vielzahl von Halbleiterleistungssteuerungseinrichtungen in einer Gruppe Leitungsunterbrechungs-Schutzauslösungen innerhalb einer vorbestimmten Zeit auftreten.

4. Verfahren gemäß einem der vorhergehenden Ansprüche, wobei ein Störlichtbogenschutz für die Dauer einer Überspannung ausgeschaltet wird.

## Revendications

1. Procédé de commande d'un contrôleur d'alimentation à l'état solide, comprenant l'étape consistant à autoriser sélectivement un courant à travers un commutateur de commande d'alimentation à l'état solide en réponse à l'activation d'une pluralité de déclenchements de protection de circuit de disjoncteur dans une pluralité de contrôleurs d'alimentation à l'état solide pendant une période temporelle prédéterminée.

2. Procédé selon la revendication 1, dans lequel un déclenchement de protection de circuits de disjoncteur est activé si un contrôleur d'alimentation à l'état solide fait face à de multiples déclenchements instantanés pendant une période temporelle prédéterminée, dans lequel chaque déclenchement instantané est en réponse au fait qu'un courant transitoire circulant à travers le contrôleur d'alimentation à l'état solide dépasse un seuil de déclenchement instantané.

3. Procédé selon la revendication 1 ou 2, dans lequel un déclenchement de protection de circuit de disjoncteur est réinitialisé si de multiples contrôleurs d'alimentation à l'état solide dans un groupe font face à des déclenchements de protection de circuit de disjoncteur pendant une période temporelle prédéterminée.

4. Procédé selon l'une quelconque des revendications précédentes, dans lequel une protection contre les défauts d'arc est désactivée pour la durée d'une surtention.
